# EUROPEAN PATENT APPLICATION

(11) **EP 3 681 252 A1**
(43) Date of publication of application: **15.07.2020**
(21) Application number: 19188507.8
(22) Date of filing: 26.07.2019
(51) Int. Cl.: H05B 45/44, F21S 41/153, F21V 23/00, H01L 27/15

(54) **ILLUMINATION APPARATUS FOR VEHICLE**

(30) Priority: 11.01.2019 TW 108101433
(71) Applicant: Everlight Electronics Co., Ltd., New Taipei City 23860 (TW)
(72) Inventor: LI, Shun-Chang, Taipei City 11280 (TW)
(74) Representative: Becker & Kurig Partnerschaft Patentanwälte PartmbB

(57) **Abstract**

An illumination apparatus for vehicle is disclosed, which includes an illumination module and a microcontroller. The illumination module includes a circuit base and an LED array which is disposed on the circuit base and includes a plurality of LED packages. Each of the LED packages includes a driver chip, a light source and a packaging structure, in which the driver chip and the light source are disposed. The driver chip is electrically connected to the light source to drive the light source to emit lights. The microcontroller is electrically connected to the LED packages to control the operation of the LED packages. Therefore, lights emitted from the LED packages can form a dynamic or static image; moreover, the light source (LED chip) and the driver chip are in the same packaging structure, so the circuit layout of the circuit base can be simplified.

## Description

### BACKGROUND OF THE INVENTION

### Field of the Invention

The present invention provides an illumination apparatus, and more particularly, an illumination apparatus for a vehicle.

### Descriptions of the Related Art

Vehicles (such as automobiles or motorcycles) all have a plurality of illumination apparatuses which emit light to lighten roads or the like so that drivers can observe the roads clearly, thereby, improving driving safety. Moreover, the light emitted by the illumination apparatus can also indicate the behaviors of the vehicles, e.g., braking, turning, reversing or the like, so that other vehicles or pedestrians can observe and respond to these behaviors accordingly.

More of the aforesaid illumination apparatuses for vehicles are utilizing light-emitting diode (LED) chips as light sources. The LED chip is packaged within a package, and the package is then connected with a driving element. Because illumination apparatuses usually use a plurality of packages of LED chips to emit light to provide sufficient luminance, and each package of LED chips needs to be connected to the respective driving element, the wiring design of the circuit board is quite complicated. Thus, to provide the arrangement space for the wirings, the intervals between the packages on the circuit board are large, so the volume of the illumination module constituted overall by the packages is relatively large. When the volume of the illumination module is large, the freedom of the design of the optical elements used in combination with the illumination module will also be restricted.

On the other hand, since the LED chip and the driving element are packaged separately (i.e., the package of the LED chip and the package of the driving element are manufactured independently and separate from each other), the LED chip and the driving element need to be purchased and stored individually, which inevitably increases the cost of the illumination apparatus on the whole. Moreover, the LED chip and the driving element are packaged separately, so it is hard for the driving element to diagnose the temperature of the LED chip without a feedback mechanism (e.g., for increasing the current to improve the circuit).

In addition to the aforesaid aspects, although the illumination apparatuses for vehicles can enable the light of the LED chips to flicker to provide indicating effects, it is hard for the illumination apparatuses to enable the light of the LED chips to form a display pattern and further enable the dynamic or diversified change of the pattern.

Accordingly, there are still many problems that need to be solved in the technical field of the illumination apparatuses for vehicles.

### SUMMARY OF THE INVENTION

One of the objectives of the present invention is to provide an illumination apparatus for a vehicle, which arranges a plurality of LED packages into an array and controls the operation of these LED packages so that the generated light can form a dynamically variable pattern or a static pattern.

One of the objectives of the present invention is to provide an illumination apparatus for a vehicle, which integrates a light source (an LED chip) and a driver chip into the same package to improve relevant problems such as the wiring design of the circuit base, and the volume, cost and/or feedback mechanism of the illumination module.

To achieve the aforesaid objectives, an illumination apparatus provided by the present invention comprises: an illumination module, including a first circuit base and a first LED array. The first LED array is disposed on the first circuit base and comprises a plurality of first LED packages. Each of the first LED packages comprises a first driver chip, a first light source and a first packaging structure. The first driver chip and the first light source are disposed within the first packaging structure. The first driving chip is electrically connected to the first light source, to drive the first light source to emit light, and a first microcontroller that is electrically connected to the first LED packages to control the operation of the first driver chips of the first LED packages.

According to an embodiment of the present invention, the illumination apparatus further comprises a housing module which includes a base and an outer cover, wherein the outer cover is disposed on the base, and the illumination module is disposed within the housing module.

According to an embodiment of the present invention, the first light source comprises one LED chip or a plurality of LED chips. The first driver chip is electrically connected to the LED chip(s) to drive the LED chip(s) to emit light.

According to an embodiment of the present invention, one or more of the LED chips is/are configured to emit blue light, green light, red light, white light or yellow light.

According to an embodiment of the present invention, the first packaging structure comprises a housing and a conductive lead frame. The conductive lead frame is partially covered by the housing. The conductive lead frame comprises a first lead and a second lead that are separated from each other. The first driver chip and the first light source are disposed on the first lead and the second lead respectively.

According to an embodiment of the present invention, the first circuit base comprises a circuit board and a wall. The first LED array is disposed on the circuit board, and the wall surrounds the circuit board of the first LED array.

According to an embodiment of the present invention, some or all of the first LED packages are electrically connected with each other in series.

According to an embodiment of the present invention, the first driving chip comprises a sensing circuit that is configured to sense the temperature and/or voltage of the first light source.

According to an embodiment of the present invention, the illumination module further comprises a first optical element. The first optical element is disposed on the light-exiting side of the first LED array.

According to an embodiment of the present invention, the first optical element comprises at least one of a light diffusing sheet, a light guiding element, an optical lens, a light shielding element and a prism.

According to an embodiment of the present invention, the light shielding element comprises a plurality of openings, and these openings are separated from each other and respectively correspond to the first LED packages.

According to an embodiment of the present invention, the illumination module further comprises a second circuit base and a second LED array. The second LED array is disposed on the second circuit base and comprises a plurality of second LED packages. Each of the second LED packages comprises a second driver chip, a second light source and a second packaging structure. The second driver chip and the second light source are disposed within the second packaging structure. The second driver chip is electrically connected to the second light source to drive the second light source to emit light.

According to an embodiment of the present invention, the first microcontroller is also electrically connected to the second LED packages to control operation of the second driver chips of the second LED packages.

According to an embodiment of the present invention, the illumination module further comprises a second microcontroller, and the second microcontroller is electrically connected to the second LED packages to control the operation of the second driver chips of the second LED packages.

According to an embodiment of the present invention, the second light source comprises one LED chip or a plurality of LED chips. The second driver chip is electrically connected to the LED chip(s) to drive the LED chip(s) to emit light.

According to an embodiment of the present invention, the second light source comprises one LED chip, while the second driver chip is electrically connected to the LED chip to drive the LED chip to emit light.

According to an embodiment of the present invention, the second circuit base comprises a ladder platform and a plurality of circuit boards. The circuit boards are disposed on the ladder platform. The second LED packages are respectively disposed on the circuit boards.

According to an embodiment of the present invention, the illumination module further comprises a second optical element. The second optical element is disposed on the light-exiting side of the second LED array.

The present invention further provides an illumination module, which comprises the following: (1) a first circuit base; (2) a first LED array, with a plurality of first LED packages that are connected in series and disposed on the first circuit base. Each of the LED packages forms an electrical connection with the first circuit base. Each of the first LED packages comprises a driver chip and a plurality of LED chips. The driver chip controls the current input to the LED chips to control light luminance of the LED chips. The illumination module also consists of a first microcontroller that is configured to give instructions to the driver chips of the LED packages to control the color and luminance displayed through the driver chips of the LED packages.

The driver chip of each of the LED packages is configured to control the magnitude of the current input to the LED chips and/or time during which the current flows in the LED chips to control the luminance of light emitted from the LED chips.

Each of the driver chips is further provided with a sensing circuit, which is configured to sense at least one selected from a group formed by temperature and voltage.

Each of the driver chips may sense the temperature of the heat generated inside the package where the driver chip is located. When the temperature of the LED chip is higher than a preset value, the driver chip feedbacks and compensates the luminance of the LED chips by controlling the current of the LED chips. In implementation, the driver chip may improve the current of the red LED chip and/or the time during which the current flows in the red LED chip. The driver chip may also be used to reduce the magnitude of current of the green/blue LED chips and/or the time during which the current flows in the green/blue LED chips to maintain the color set originally after light mixing.

The driving chip may selectively control the current of the LED chips, i.e., may control a certain LED chip independently or may control multiple LED chips together.

The driving chip has the function of detecting an open circuit. In implementation, the voltage may be detected. If the voltage exceeds a preset threshold, it is a short circuit. If the voltage is lower than the preset threshold, it is an open circuit.

The LED chips in each of the LED packages may be selectively arranged in different numbers and different colors.

Accordingly, the illumination apparatus of the present invention at least may provide the following benefits:
1. The LED packages are arranged in an array, and the microcontroller may control the operation of the LED packages (whether to emit light or not, light emitting time, light luminance, colors or the like) according to a written program so that the light generated by these LED packages may constitute a dynamic or static pattern.
2. The light source (the LED chip) and the driver chip of each LED package are disposed within the same packaging structure (not packaged individually) and are electrically connected with each other. Therefore, when the plurality of LED packages constitute an array, the wiring between the LED packages or the circuit design of the LED packages may be easier, and the intervals between the LED packages may be smaller. In other words, in a same unit area, the LED array may comprise more LED packages, thereby providing patterns of better resolution.
3. The LED array may be used in combination with optical elements to change or guide light emitted by the LED array so that the light can form different shapes. Moreover, each LED package of the LED array may comprise LED chips of different wavelengths (e.g., red, green and blue LEDs), so the light emitted by the LED array can form colorful patterns.
4. Because the LED chip and the driver chip are disposed within the same packaging structure, the LED package may have a smaller size overall, and may also reduce the cost. Moreover, if the driver chip has a temperature sensing function, the driver chip can further sense the temperature of the LED chip and then adjust the current supplied to the LED chip. In this way, the reduction in the light emitting efficiency of, for example, the red LED chip due to the rise in the temperature can be compensated.

The detailed technology and preferred embodiments implemented for the subject invention are described in the following paragraphs accompanying the appended drawings for people skilled in this field to well appreciate the features of the claimed invention.

### BRIEF DESCRIPTION OF THE DRAWINGS

**FIG. 1A** and **FIG. 1B** are perspective exploded views of an illumination apparatus according to the preferred embodiment of the present invention;
**FIG. 2A** and **FIG. 2B** are a perspective exploded view and a partially enlarged view of an illumination apparatus according to the preferred embodiment of the present invention;
**FIG. 3** is a perspective view of an illumination module of an illumination apparatus according to the preferred embodiment of the present invention;
**FIG. 4** is a perspective view of an LED package of an illumination apparatus according to the preferred embodiment of the present invention;
**FIG. 5A** and **FIG. 5B** are front and cross-sectional views of an LED package according to the preferred embodiment of the present invention;
**FIG. 6A** and **FIG. 6B** are schematic circuit views of an illumination apparatus according to the preferred embodiment of the present invention;
**FIG. 7A** to **FIG. 7D** are views illustrating the arrangement of LED chips of an LED package of an illumination apparatus according to the preferred embodiment of the present invention;
**FIG. 8** is a schematic view illustrating the change in the display pattern of an illumination apparatus according to the preferred embodiment of the present invention;
**FIG. 9A** to **FIG. 9C** are schematic views illustrating the display pattern of an illumination apparatus according to the preferred embodiment of the present invention; and
FIG. **10** is a schematic view illustrating another change in the display pattern of an illumination apparatus according to the preferred embodiment of the present invention.

### DESCRIPTION OF THE PREFERRED EMBODIMENT

Specific embodiments of the present invention will be described specifically hereinafter. However, the present invention may be implemented with various different forms of embodiments without departing from the spirit of the present invention, and the scope claimed in the present invention should not be construed as being limited to what is described in the specification. Additionally, the technical contents of various implementations in the above summary of the invention may also serve as the technical contents of the embodiments or as possible variants of the embodiments. Moreover, the orientation described hereinafter (e.g., front, back, upper, lower, two sides or the like) are opposite orientations, and may be defined according to the use status of the illumination apparatus.

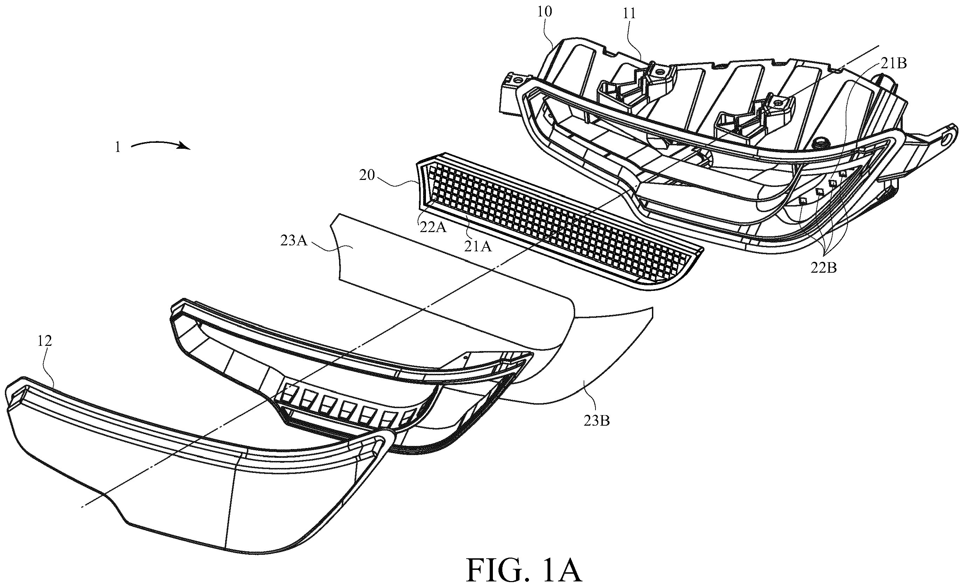

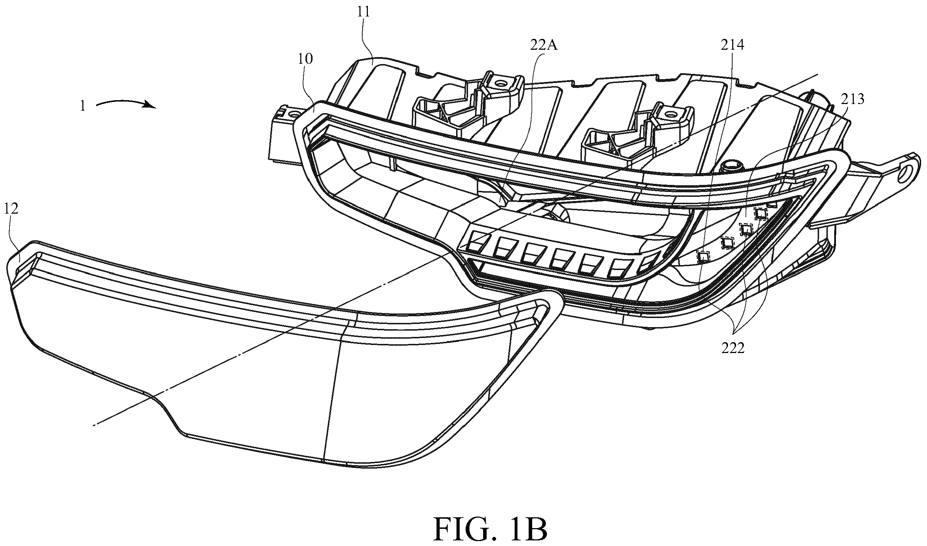

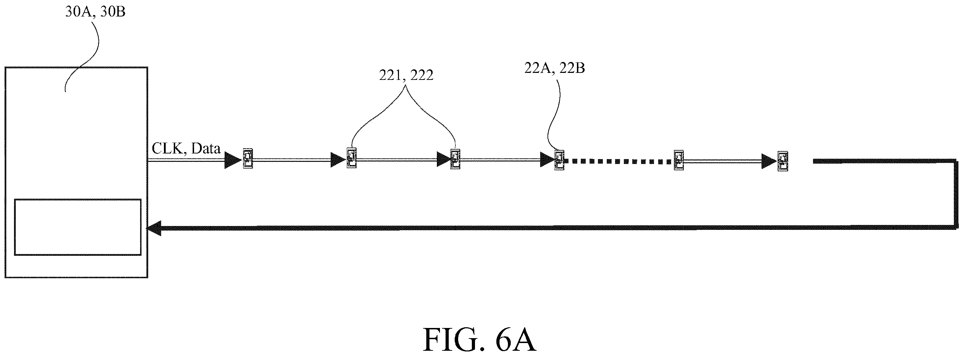

With reference to **FIGs. 1A** and **1B**, which are perspective exploded views of an illumination apparatus **1** according to the preferred embodiment of the present invention. The illumination apparatus **1** may be used for a vehicle (e.g., an automobile, a motorcycle, a bicycle, a scooter or the like) as a component of the vehicle and may generate illumination or light for indication. In this embodiment, the tail lamps of an automobile are taken as an application example of the illumination apparatus **1**. However, the illumination apparatus **1** is not limited thereto. The illumination apparatus **1** may comprise a housing module **10**, an illumination module **20** and a first microcontroller **30A** (which is referred to as a microcontroller **30A** hereinafter, as shown in **FIG. 6A**). The technical contents of these elements will be described sequentially as follows.

The housing module **10** is a lamp housing shaped for the tail lamp of the automobile applied, and it may vary in response to the overall shape of the automobile. Structurally, the housing module **10** comprises a base **11** and an outer cover **12.** The base **11** may be a hollow structure with a side thereof formed as an opening for providing a receiving space, so the illumination module **20** may be received in the base **11** through the opening. The base **11** may also comprise a fixing structure (e.g., a threaded hole, a fastener or the like) therein so that the illumination module **20** can be fixed within the base **11**. The base **11** may mainly be made of an opaque and non-conductive material (or a material of poor transparency or conductivity), e.g., a plastic material, so the light generated by the illumination module **20** is not expected to emit from portions other than the opening of the base **11**. The outer cover **12** is disposed (covered) above the base **11** and is disposed at the opening side of the base **11** and closes the opening. The outer cover **12** is mainly made of a light-transmissive and non-conductive material, so the light generated by the illumination module **20** may be emitted to the outside through the outer cover **12**. In an embodiment, the base **11** and the outer cover **12** are used to cover the illumination module **20**. In an embodiment, the inner side surface of the base **11** may be coated with a layer of reflective material to reflect the light of the illumination module **20**.

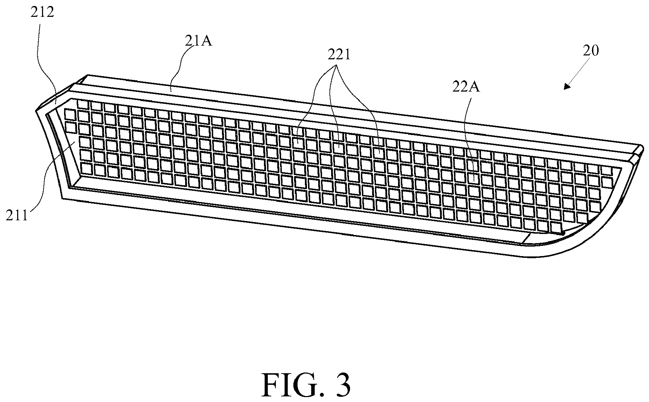

Referring to the perspective view of the illumination module **20** shown in **FIG. 3** together, the illumination module **20** is disposed within the base **11** to generate light that can form specific and preset patterns. The illumination module **20** comprises a first circuit base **21A** (which is referred to as a circuit base **21A** hereinafter) and a first LED array **22A** (which is referred to as an LED array **22A** hereinafter). The circuit base **21A** is configured to be fixed with the base **11**, support the LED array **22A** and provide a circuit for transmitting signals and electrical energy to the LED array **22A**. The circuit base **21A** comprises a circuit board **211**, and the substrate thereof may be a type of substrate that shall be well known in the art, e.g., a plastic substrate, a ceramic substrate or a metal substrate or the like, and a circuit or the like is disposed within the substrate or on the surface of the substrate. The LED array **22A** is disposed on the circuit board **211** and electrically connected with the circuit board **211**. The circuit base **21A** may selectively further comprise a wall **212**. The wall **212** may be disposed on the circuit board **211** or may be larger than the circuit board **211** to surround the circuit board **211**. Moreover, the wall **212** surrounds the LED array **22A**. The wall **212** is made of an opaque or reflective material, so the wall **212** may reflect the light to limit the light-emitting angle (range) of the LED array **22A**.

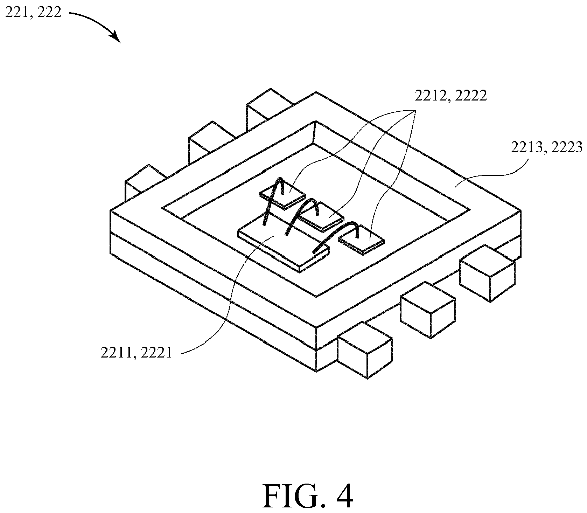

The LED array **22A** comprises a plurality of first LED packages **221** (which is referred to as LED packages **221** hereinafter), these LED packages **221** are arranged into a two-dimensional array of any shape, e.g., a 5×40 array, and the number of the LED packages **221** in each column may be different. Each LED package **221** may be controlled to emit light of a particular color (wavelength) or intensity. Please refer to the perspective view of the LED packages **221** shown in **FIG. 4** together. Each of the LED packages **221** comprises a first driver chip **2211** (which is referred to as a driver chip **2211** hereinafter), a first light source **2212** (which is referred to as a light source **2212** hereinafter) and a first packaging structure **2213** (which is referred to as a packaging structure **2213** hereinafter). The driver chip **2211** and the light source **2212** are all disposed within the packaging structure **2213** (in other words, the driver chip **2211** and the light source **2212** are packaged together rather than being separated), so the space and the cost can be saved. In an embodiment, the light source **2212** may be of a multiple-chip design formed by at least one light-emitting diode chip or laser diode chip.

The driver chip **2211** is further electrically connected to the light source **2212** within the packaging structure **2213** to drive the light source **2212** to emit light. The light source **2212** may comprise one or a plurality of LED chips (i.e., at least one LED chip). Each LED chip is electrically connected with the driver chip **2211** individually to be driven independently to emit light. The driver chip **2211** may also drive a plurality of LED chips **2212** together. In this embodiment, three LED chips **2212** are taken as an example and are respectively configured to emit red light, green light and blue light. In an embodiment, the light emitted by the LED chips **2212** may be the same, partially the same or different. The driver chip **2211** and the LED chip **2212** may be horizontal chips, and may also be vertical chips or flip chips.

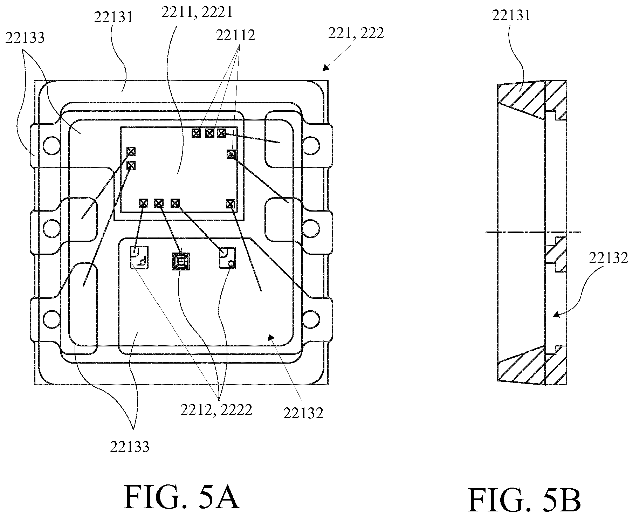

With reference to the front and cross-sectional views of the LED package **221** shown in both **FIGs. 5A** and **5B**, the packaging structure **2213** may comprise a housing **22131** and a conductive lead frame **22132**. The conductive lead frame **22132** is partially covered by the housing **22131**, and the part of the conductive lead frame **22132** may be used for connection with other elements. The conductive lead frame **22132** may further comprise a plurality of leads **22133**. The two leads that are separated from each other are defined as a first lead and a second lead, and the driver chip **2211** and the light source (LED chip) **2212** are respectively disposed on the two leads. The contacts of the driver chip **2211** are wire bonded to the light source **2212** and the leads **22133** to form an electrical connection. The packaging structure **2213** may further comprise one or more types of encapsulant gel (not shown) to cover and protect the light source **2212** and the driver chip **2211**, wherein the encapsulant gel covering the light source **2212** is light transmissive. In an embodiment, contacts **22112** of the driver chip **2211** include a power input terminal (VCC), a ground terminal (GND), a data input terminal (DAi), a data output terminal (DAo), a clock input terminal (CKi), and a clock output terminal (CKo). The voltage input terminal (VCC), these contacts **22112** are configured to electrically connected to the light sources (LED chips) **2212** and the leads **22133** respectively.

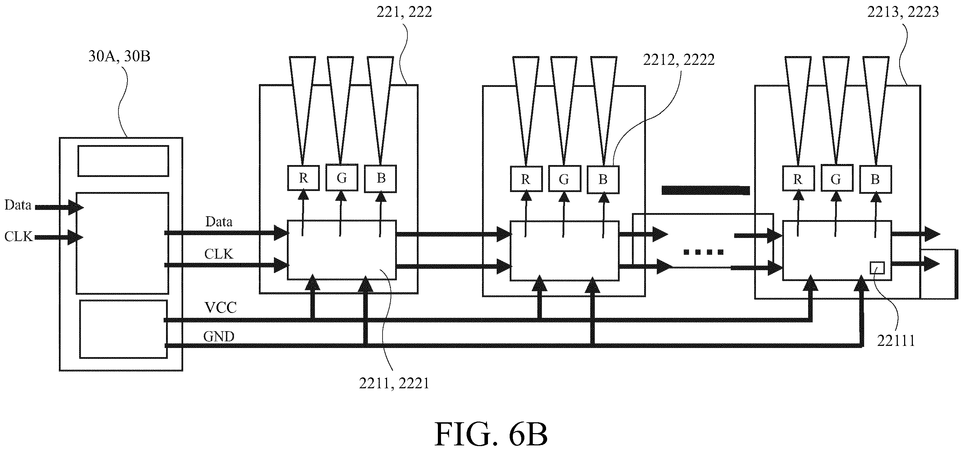

Moreover, the driver chip **2211** may preferably further comprise a sensing circuit **22111** (as shown in **FIG. 6B**) to sense the temperature and/or voltage of the light source (LED chip) **2212**. Therefore, if the temperature of the LED chip **2212** changes and thus causes a reduction in the light-emitting efficiency, then, the driver chip **2211** may adjust the current supplied to the LED chip **2212** to maintain the preset luminance. For example, if the temperature is higher than a preset value, then the driver chip **2211** may improve the current value of the red LED chip **2212** or the time during which the current passes through the red LED chip **2212**. It may also reduce the current value of the blue and green LED chips **2212** or the time during which the current passes through the blue and green LED chips **2212** so that the preset color can still be maintained after mixing the red light, green light and blue light. Moreover, the driver chip **2211** senses whether the voltage of the LED chip **2212** exceeds a preset value to determine whether the circuit of the LED chip **2212** is a short circuit or open circuit.

With reference to the element layout diagram of the illumination apparatus **1** shown in both **FIGs. 6A** and **6B**, the microcontroller **30A** is electrically connected to the LED packages **221** to control the operation of the driver chips **2211** of the LED packages **221**. That is, the microcontroller **30A** may give instructions to the driver chips **2211** of the LED packages **221** to control the color and/or luminance displayed through the driver chips **2211**. The microcontroller **30A** may be disposed outside the housing module **10**, e.g., disposed in an electronic control unit (ECU) of the vehicle which may also be referred to as a vehicle-mounted computer. Then, the microcontroller **30A** is electrically connected to the circuit base **21A** through a transmission line, and then electrically connected to the LED array **22A**. In other words, the ECU may also be regarded as an implementation of the microcontroller **30A**. Alternatively, the microcontroller **30A** may be directly disposed on the circuit base **21A**, and then electrically connected to the ECU or other electronic apparatuses through the transmission line.

Moreover, some or all of the LED packages **221** can be electrically connected with each other in series and then electrically connected with the microcontroller **30A**. In this way, as compared to the case of parallel connection among the LED packages **221**, the circuit design of the circuit base **21A** may be simpler so that the LED packages **221** can be arranged closer to each other. In an implementation, the microcontroller **30A** may have a data transmission line and a clock (CLK) transmission line connected with the driver chip **2211** of the LED package **221**, and the driver chip **2211** determines to drive which LED chip **2212** to emit light, the light luminance and the light-emitting time or the like according to the content of the data signal received. Moreover, the microcontroller **30A** may also have the power (VCC) transmission line and the ground (GND) transmission line connected with the driver chip **2211**. The microcontroller **30A** may control the LED chip **2212** with pulse-width modulation (PWM), i.e., the microcontroller **30A** outputs a pulse signal to the driver chip **2211** and then the driver chip **2111** lightens the LED chip **2212** according to the width of the pulse. The driver chip **2211** may also output an error detection signal to the microcontroller **30A** to indicate which LED chip **2212** is defective or the like. In an embodiment, the microcontroller **30A** and the driver chip **2211** may be application-specific integrated circuits (ASICs), complex programmable logic devices (CPLDs) or field programmable gate array (FPGA).

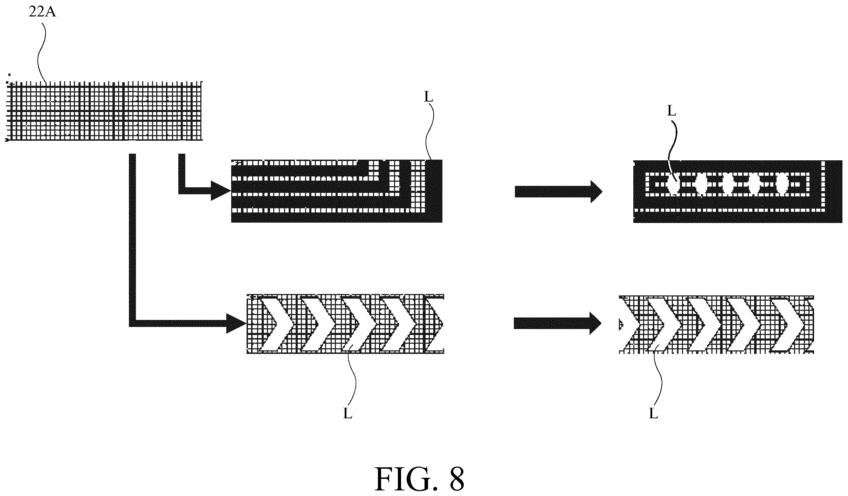

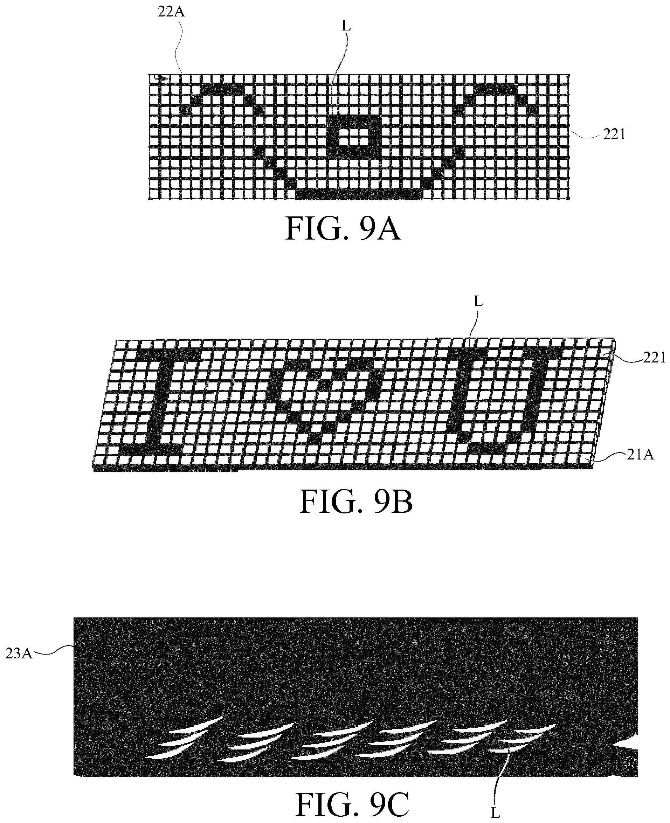

Accordingly, the microcontroller **30A** may control an LED package **221** at a specific location to emit light according to a set program so that the light **L** emitted overall by the LED array **22A** may form a pattern, and the pattern may change dynamically or sequentially (as shown in **FIG. 8**), or the pattern may also be a static pattern (as shown in **FIG. 9A** and **FIG. 9B**). Moreover, since the LED packages **221** are arranged closer to each other, there may be more LED packages **221** within a unit size, so the pattern formed can have higher resolution. In an embodiment, the pattern may be a static or dynamic word, figure or any combination thereof. In an embodiment, the luminance of the pattern may be fixed continuously or changed dynamically. In an embodiment, the pattern may be planar, three-dimensional or of a visual design of any combination thereof.

On the other hand, because each LED package **221** comprises LED chips **2212** of three colors, i.e., red (R), green (G) and blue (B), the pattern displayed overall by the LED array **22A** may be colorful. The microcontroller **30A** may also lighten all the LED packages **221** at the same time to emit light of the same color, e.g., emit red light to represent deceleration or stop of the vehicle, emit yellow light to signal turning of the vehicle, or emit white light to signal reversing of the vehicle or the like. Additionally, during the deceleration or stop of the vehicle, the microcontroller **30A** may control larger current to flow in the LED package **221** to increase the luminance of the red light.

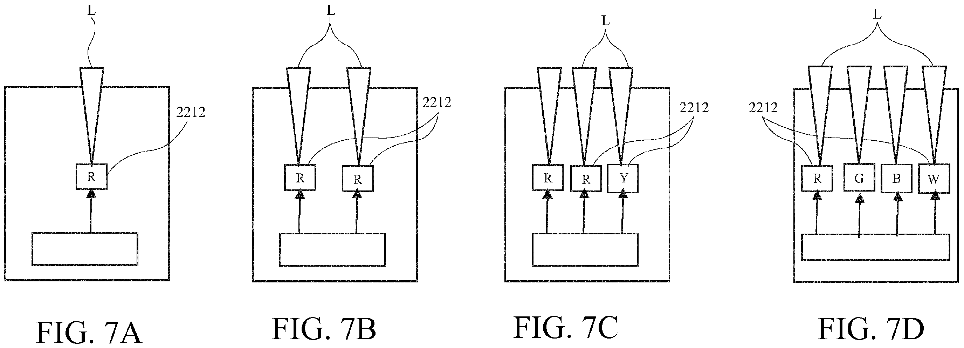

In addition to the LED chips **2212** of the three colors R, G and B, the LED package **221** may also select other arrangements of the LED chips. Referring to **FIG. 7A**, the light source **2212** of the LED package **221** may comprise an LED chip (e.g., a red LED chip **R**), so the pattern displayed overall by the LED array **22A** is of a single color. With reference to **FIG. 7B**, the light source **2212** may comprise a plurality of LED chips, which are all red LED chips **R** for example, to increase the luminance of the red light so that it is easier to draw the attention of drivers of other vehicles or pedestrians. With reference to **FIG. 7C**, the light source **2212** may comprise a plurality of LED chips, some are red LED chips **R** while others may have a yellow LED element **Y** constituted by a blue (or ultraviolet) LED chip and fluorescent powder or the like for example. With reference to **FIG. 7C**, the light source **2212** may comprise a red LED chip **R**, a green LED chip **G** and a blue LED chip **B**, and further comprise a white LED element **W** constituted by a blue LED and fluorescent powder or the like for example to increase the color quality of the white color of the pattern. The fluorescent materials may be mixed in the encapsulant gel and then covered on the LED chip, or the fluorescent materials may be a fluorescent patch disposed on the LED chip. In an embodiment, the light sources **22112** may be multiple light-emitting diode chips emitting light of the same color, partially same color or different colors. In an embodiment, the light sources **22112** may be multiple laser diode chips emitting light of the same color, partially same color or different colors. In an embodiment, the light sources **22112** may be multiple light-emitting diode chips and laser diode chips emitting light of the same color, partially the same color or different colors. In an embodiment, the light sources **22112** may be visible-light and invisible-light LED chips. In an embodiment, the light sources **22112** may be a combination of visible-light and invisible-light LED chips and laser diode chips.

With reference back to **FIGs. 1A** and **1B**, the illumination module **20** may selectively further comprise a first optical element **23A** (which is referred to as an optical element **23A**) which is disposed at a light-exiting side (i.e., a side opposite to the circuit base **21A** and towards the outer cover **12**) of the LED array **22A** to change the path or angle of the light emitted by the LED array **22A** so that the pattern constituted by the light is variable. In this embodiment, a light diffusing sheet is taken as an example of the optical element **23A**. The light diffusing sheet can change the pattern of the light into a curved form, as shown in **FIG. 9C**. The distance and angle between the optical element **23A** and the LED array **22A** will all cause change in the pattern presented by the light, and in this embodiment, the optical element **23A** abuts against the circuit base **21A** and is spaced from the LED array **22A** at a specific distance. In addition to the shape of a planar sheet, the optical element **23A** may also be curved, and the curvature thereof will also influence the pattern presented by the light. The technical content of the optical element **23A** may comprise the disclosure of Taiwan Patent Application No. 107101069, and this application is incorporated herein in its entirety by reference.

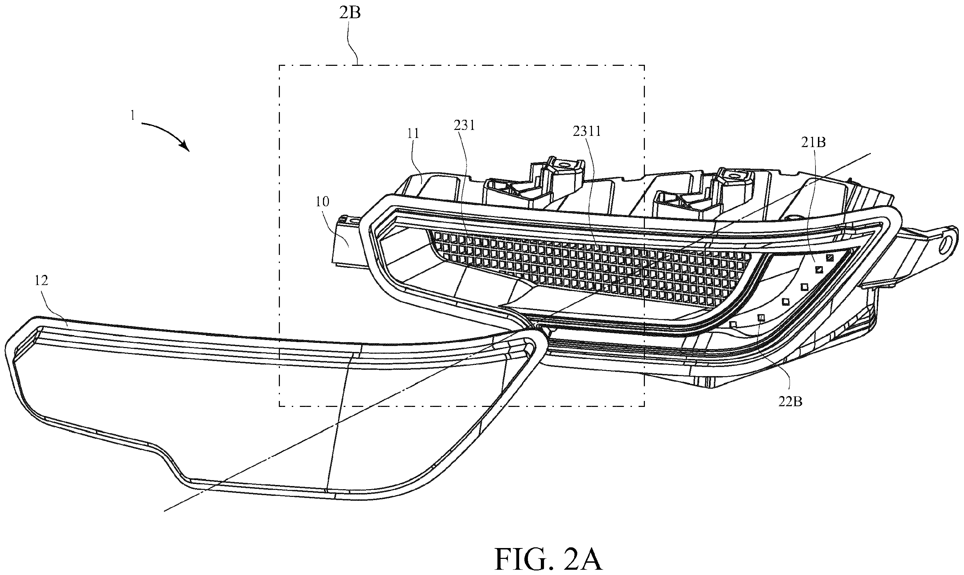

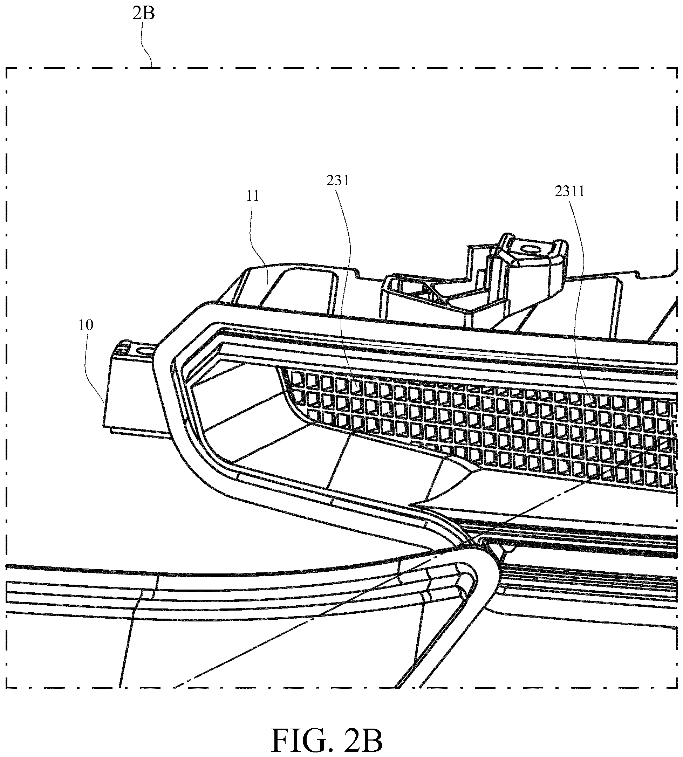

In addition to the light diffusing sheet, the optical element **23A** may also comprise one or a combination of a light guiding element, an optical lens and a prism. **FIGs. 2A** and **FIG. 2B** are a perspective exploded view and a partially enlarged view of another embodiment of the illumination apparatus **1**, respectively. The optical element **23A** may further comprise a light shielding element **231** comprising a mesh and grid structure, i.e., comprising a plurality of openings **2311**. The openings **2311** are separated from each other and do not communicate with each other, so the light can pass through an opening **2311** along the depth direction of the opening **2311**, but the light cannot reach other openings **2311** along the width direction (length direction) of the opening **2311** (light will be blocked by the opaque part of the light shielding element **231** between the openings **2311**). These openings **2311** respectively correspond to the LED packages **221**, i.e., the location and the size of the openings **2311** all correspond to the location and size of the LED packages **221**, so these openings **2311** are also arranged into an matrix, and the size (length, width) of the openings **2311** is equal to or slightly larger than the LED packages **221**. Thus, the openings **2311** may prevent light emitted by adjacent LED packages **221** from being mixed, thereby increasing the contrast of the pattern presented by the light.

With reference back to **FIGs. 1A** and **1B**, the illumination module **20** may also further comprise a second circuit base **21B**, a second LED array **22B** and a second optical element **23B** so that the illumination module **20** can provide another display pattern. The technical contents of these elements are respectively similar to those of the circuit base **21A**, the LED array **22A** and the optical element **23A**, so reference may be made to the technical contents of the circuit base **21A**. The LED array **22A** and the optical element **23A** for the technical contents of the second circuit base **21B**, the second LED array **22B** and the second optical element **23B** and vice versa and the technical contents of these elements will be described in brief hereinafter.

The second LED array **22B** is disposed on the second circuit base **21B** and comprises a plurality of LED packages **222**. The second circuit base **21B** is located beside the circuit base **21A** and may be located in front of the circuit base **21A**. The second circuit base **21B** and the circuit base **21A** may also possibly be electrically connected through a transmission line. The shape of the second circuit base **21B** is not a planar sheet, and instead, the second circuit base **21B** is step-shaped in response to the shape of the base **11** of the housing module **10**. That is, the second circuit base **21B** may comprise a ladder platform **213** and a plurality of circuit boards **214**. The ladder platform **213** has a plurality of planes that are separated from each other in the longitudinal direction, and the circuit boards **214** are disposed on the ladder platform **213**, i.e., disposed respectively on these planes. These LED packages **222** are respectively disposed on these circuit boards **214**, and since these circuit boards **214** are separated from each other in the longitudinal direction, these LED packages **222** are also separated from each other in the longitudinal direction (i.e., separated from each other in the light-emitting direction). Moreover, a one-dimensional array (e.g., a 1×5 array) is taken as example of the LED packages **222**.

With reference to **FIGs. 4**, **5A** and **5B** together, the LED package **222** also comprises a second driver chip **2221**, a second light source **2222** and a second package structure **2223**. The second driver chip **2221** and the second light source **2222** are disposed within the second package structure **2223**. The second driver chip **2221** is electrically connected to the second light source **2222** to drive the second light source **2222** to emit light. The second light source **2222** may comprise one or a plurality of LED chips electrically connected with the second driver chip **2221**, and the color of the light emitted by the LED chips and the number of the LED chips may be selected depending on requirements.

With reference to both **FIGs. 6A** and **6B**, the LED package **222** may be electrically connected to the microcontroller **30A**, so the microcontroller **30A** is connected with two sets of LED packages **221** and **222** at the same time and may individually or simultaneously control the LED packages **221** and **222**. The LED package **222** may also be electrically connected to the microcontroller **30B** and independently controlled by the microcontroller **30B**. The second optical element **23B** is disposed at the light-exiting side of the second LED array **22B** to change the path or angle of the light emitted by the second LED array **22B**. In an embodiment, the microcontrollers **30A** and **30B** may be a same microcontroller.

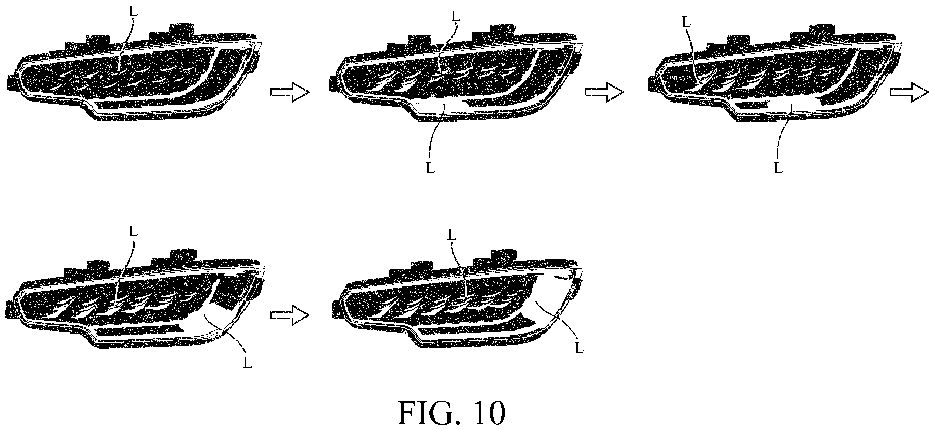

Referring to a schematic view illustrating the change in the display pattern of the illumination module **20** shown in FIG. **10**, the first LED array **22A** and the second LED array **22B** may provide different display patterns to achieve different indication purposes. For example, the light **L** emitted by the first LED array **22A** is line-shaped and becomes thicker and more sequentially to represent the braking of the vehicle. The light **L** emitted by the second LED array **22B** moves rightwards sequentially to represent the turning of the vehicle. In an embodiment, under the control of the microcontrollers **30A** and **30B** as well as the driver chips **2211** and **2221** (as shown in **FIG. 6B**), the LED arrays **22A** and **22B** (as shown in **FIG. 1A**) may present unlimited changes in patterns, and may present dynamic or sequential patterns, or perform communication between vehicles or between a vehicle and a person.

What has been described above are only the embodiments of the present invention, but are not intended to limit the scope of the present invention. Any equivalent structures or equivalent process flow modifications that are made according to the specification and the attached drawings of the present invention, or any direct or indirect applications of the present invention in other related technical fields shall all be covered within the scope of the present invention.

The above embodiments are only used for describing technical solutions of the present invention rather than for limiting the present invention. Although the present invention has been described in detail with reference to the above embodiments, these of ordinary skill in the art shall appreciate that: modifications to technical solutions recorded in the above embodiments or equivalent displacements for some or all technical features in the above embodiments are still possible, and these modifications or displacements will not cause the corresponding technical solution to substantially depart from the scope of the technical solutions of the embodiments of the present invention.

## Claims

1. An illumination apparatus (1) for a vehicle, comprising:
an illumination module (20), including a first circuit base (21A) and a first LED array (22A), the first LED array (22A) being disposed on the first circuit base (21A) and comprising a plurality of first LED packages (221), each of the first LED packages (221) comprising a first driver chip (2211), a first light source (2212) and a first packaging structure (2213), the first driver chip (2211) and the first light source (2212) being disposed within the first packaging structure (2213), and the first driver chip (2211) being electrically connected to the first light source (2212) so as to drive the first light source (2212) to emit light; and
a first microcontroller (30A), being electrically connected to the first LED packages (221) so as to control operation of the first driver chips (2211) of the first LED packages (221).

2. The illumination apparatus (1) of Claim 1, further comprising a housing module (10) including a base and an outer cover, wherein the outer cover is disposed on the base, and the illumination module (20) is disposed within the housing module (10).

3. The illumination apparatus (1) of Claim 1, wherein the first light source (2212) comprises at least one LED chip, and the first driver chip (2211) is electrically connected to the at least one LED chip so as to drive the at least one LED chip to emit light.

4. The illumination apparatus (1) of Claim 3, wherein the LED chips emit blue light, green light and red light, respectively.

5. The illumination apparatus (1) of Claim 1, wherein the first packaging structure (2213) comprises a housing (22131) and a conductive lead frame (22132), the conductive lead frame (22132) is partially covered by the housing (22131), the conductive lead frame (22132) comprises a first lead and a second lead that are separated from each other, and the first driver chip (2211) and the first light source (2212) are disposed on the first lead and the second lead, respectively.

6. The illumination apparatus (1) of Claim 1, wherein the first circuit base (21A) comprises a circuit board and a wall, the first LED array (22A) is disposed on the circuit board, and the wall surrounds the first LED array (22A).

7. The illumination apparatus (1) of Claim 1, wherein part or all of the first LED packages (221) are electrically connected with each other in series.

8. The illumination apparatus (1) of Claim 1, wherein the first driver chip (2211) comprises a sensing circuit that senses temperature and/or voltage of the first light source (2212).

9. The illumination apparatus (1) of Claim 1, wherein the illumination module (20) further comprises a first optical element (23A), and the first optical element (23A) is disposed at a light-exiting side of the first LED array (22A).

10. The illumination apparatus (1) of Claim 9, wherein the first optical element (23A) comprises at least one of a light diffusing sheet, a light guiding element, an optical lens, a light shielding element and a prism.

11. The illumination apparatus (1) of Claim 10, wherein the light shielding element comprises a plurality of openings, and these openings are separated from each other and respectively correspond to the first LED packages (221).

12. The illumination apparatus (1) of Claim 1, wherein the illumination module (20) further comprises a second circuit base and a second LED array, the second LED array is disposed on the second circuit base and comprises a plurality of second LED packages, each of the second LED packages comprises a second driver chip, a second light source and a second packaging structure, the second driver chip and the second light source are disposed within the second packaging structure, and the second driving chip is electrically connected to the second light source so as to drive the second light source to emit light.

13. The illumination apparatus (1) of Claim 12, wherein the first microcontroller (30A) is also electrically connected to the second LED packages so as to control operation of the second driver chips of the second LED packages.

14. The illumination apparatus (1) of Claim 12, wherein the illumination module (20) further comprises a second microcontroller, and the second microcontroller is electrically connected to the second LED packages so as to control operation of the second driver chips of the second LED packages.

15. The illumination apparatus (1) of Claim 12, wherein the second light source comprises at least one LED chip electrically connected to the second driver chip.

16. The illumination apparatus (1) of Claim 12, wherein the second circuit base comprises a ladder platform and a plurality of circuit boards, the circuit boards are disposed on the ladder platform, and the second LED packages are respectively disposed on the circuit boards.

17. The illumination apparatus (1) of Claim 12, wherein the illumination module (20) further comprises a second optical element, and the second optical element is disposed at a light-exiting side of the second LED array.
